Europäisches Patentamt

European Patent Office

Office européen des brevets

(19)

(11) Veröffentlichungsnummer : **0 059 385**
**B1**

(12) # EUROPÄISCHE PATENTSCHRIFT

(45) Veröffentlichungstag der Patentschrift :
28.11.84

(51) Int. Cl.³ : **G 03 F 7/10, G 03 F 7/02**

(21) Anmeldenummer : **82101264.8**

(22) Anmeldetag : **19.02.82**

(54) **Zur Herstellung von Druck- und Reliefformen geeignete Mehrschichten-Elemente sowie Verfahren zu ihrer Herstellung.**

(30) Priorität : **28.02.81 DE 3107741**

(43) Veröffentlichungstag der Anmeldung :
**08.09.82 Patentblatt 82/36**

(45) Bekanntmachung des Hinweises auf die Patenterteilung : **28.11.84 Patentblatt 84/48**

(84) Benannte Vertragsstaaten :
**BE DE FR GB IT NL**

(56) Entgegenhaltungen :
**EP-A- 0 002 321**
**EP-A- 0 017 336**
**DE-A- 2 301 175**
**DE-A- 2 357 356**
**DE-A- 2 555 783**
**GB-A- 1 440 734**

(73) Patentinhaber : **BASF Aktiengesellschaft**
**Carl-Bosch-Strasse 38**
**D-6700 Ludwigshafen (DE)**

(72) Erfinder : **Hoffmann, Gerhard, Dr.**
**Papelstrasse 22**
**D-6701 Otterstadt (DE)**
Erfinder : **Richter, Peter, Dr.**
**Bensheimer Ring 24**
**D-6710 Frankenthal (DE)**

EP 0 059 385 B1

**0 059 385**

**Beschreibung**

Die Erfindung betrifft Mehrschichten-Elemente mit einer auf einem Polyester-Schichtträger über eine Haftschicht fest verankerten photopolymerisierbaren und/oder -vernetzbaren Schicht auf Basis eines elastomeren Polymer-Bindemittels, die zur Herstellung von Druck- und Reliefformen mit elastomeren Reliefschichten geeignet sind und die eine verbesserte Stabilität bei der Verarbeitung und Anwendung aufweisen.

Mehrschichten-Elemente für die Herstellung von Reliefdruckplatten mit elastomeren Reliefschichten, wie sie für den Flexodruck eingesetzt werden, sind an sich bekannt und z. B. in den DE-OSen 21 38 582, 22 15 090, 24 56 439, 26 23 801 oder 29 42 183, der CA-PS 614 181 sowie den US-PSen 3 024 180 oder 3 674 486 beschrieben. Diese Mehrschichten-Elemente bestehen im allgemeinen aus einer photopolymerisierbaren und/oder photovernetzbaren Schicht einer Mischung eines Elastomeren mit photopolymerisierbaren Monomeren, die haftfest mit einem dimensionsstabilen Schichtträger, wie z. B. einer Kuntstoff-Folie oder einer Metallplatte, verbunden ist. In der DE-OS 24 44 118 wird eine Mehrschichten-Verbundplatte für die Herstellung von Reliefdruckplatten für den Flexodruck beschrieben, bei der die reliefbildende, photoempfindliche Schicht haftfest auf einer dimensionsstabilen Trägerschicht, beispielsweise aus einer Polyesterfolie, verankert ist, die ihrerseits mit einer weichelastischen Unterschicht verbunden ist. Es ist aus den zitierten Druckschriften auch bekannt, daß zur Erzielung einer festen Verankerung der photosensitiven Schicht auf dem dimensionsstabilen Träger zweckmäßigerweise eine dazwischenliegende Haftschicht verwendet wird. Für solche Haftschichten ist beispielsweise der Einsatz von handelsüblichen Ein- oder Zweikomponenten-Reaktionsklebern auf Polyurethan- bzw. Polychloropren-Basis vorgeschlagen worden. Des weiteren wurde bereits empfohlen, als Haftschicht Gemische von polymeren Bindemitteln mit Polymerisationsinitiatoren zu verwenden (vgl. z. B. EP-A2-0 002 321 und US-PS 3 036 913). Ferner ist aus der CH-PS 421 708 bekannt, dünne elastische photopolymerisierbare Elemente aus einer reliefbildenden, photopolymerisierbaren Schicht, einer Sperrschicht und einer härtbaren Klebstoffschicht auf einer elastischen Unterlage, insbesondere einer Polyethylenterephthalatfolie, in der Weise herzustellen, daß auf die mit der härtbaren Klebstoffschicht versehene Polyethylenterephthalatfolie eine Schicht der photopolymerisierbaren Masse aus Monomeren und einem verträglichen polymeren Bindemittel, wie sie auch zur Herstellung der photopolymerisierbaren reliefbildenden Schicht verwandt werden, aufgetragen und teilweise vernetzt wird, und dann eine Schicht der photopolymerisierbaren Masse für die photopolymerisierbare Bildschicht aufgetragen wird. Die härtbare Klebstoffschicht besteht dabei aus einem Mischpolyester und einem Diisocyanat als thermischem Härtemittel.

Es hat sich jedoch in der Praxis gezeigt, daß bei Mehrschichten-Elementen mit einer photosensitiven Schicht auf Basis eines elastomeren Polymeren und einem Träger aus einer Polyesterfolie die Verankerung der photosensitiven Schicht auf der Polyesterfolie auch bei Verwendung der für diese Mehrschichten-Elemente bekannten und beschriebenen Haftvermittler und Haftschichten für die praktische Anwendung nicht zufriedenstellend ist. So kommt es beim Auswaschen von belichteten photopolymeren Mehrschichten-Elementen dieser Art als auch bei der Anwendung der hieraus hergestellten photopolymeren Druck- und Reliefformen, insbesondere durch den Einfluß der hierbei verwendeten organischen Lösungsmittel, immer wieder zu Ablösungen der photopolymeren elastomeren Reliefschicht von der als Schichtträger dienenden Polyesterfolie, wodurch die Druck- oder Reliefformen unbrauchbar werden.

Der vorliegenden Erfindung lag die Aufgabe zugrunde, photosensitive, zur Herstellung von Reliefdruckformen für den Flexodruck geeignete Mehrschichten-Elemente zu schaffen, die auf einem Schichtträger aus Polyester eine photosensitive reliefbildende Schicht auf Basis eines elastomeren Polymeren fest verankert enthalten und die eine verbesserte Verbundfestigkeit zwischen reliefbildender Schicht und Schichtträger bei der Herstellung, der Verarbeitung und der Anwendung dieser Mehrschichten-Elemente sowohl im unbelichteten als auch im belichteten Zustand aufweisen.

Es wurde nun gefunden, daß zur Herstellung von Druck- und Reliefformen geeignete Mehrschichten-Elemente mit

a) einer photosensitiven Schicht einer in aromatischen oder halogenierten aliphatischen Kohlenwasserstoff-Lösungsmitteln löslichen und/oder dispergierbaren Mischung, bestehend im wesentlichen aus

a1) mindestens einem elastomeren Polymeren als Bindemittel,

a2) mindestens einem damit verträglichen photopolymerisierbaren, ethylenisch ungesättigten Monomeren,

a3) einem durch aktinisches Licht aktivierbaren Photopolymerisationsinitiator sowie

a4) ggf. üblichen Zusatzstoffen,

b) einem Polyesterformkörper als dimensionsstabilem Träger für die photosensitive Schicht (a) und

c) einer Haftschicht zwischen der photosensitiven Schicht (a) und dem dimensionsstabilen Träger (b) in einer Schichtdicke von 2 bis 25 $\mu$m, vorzugsweise von 3 bis 12 $\mu$m,

die gewünschten Eigenschaften weitgehend aufweisen, wenn die Haftschicht (c) im wesentlichen gebildet wird aus einem in den Prozeßlösungsmitteln nicht löslichen Umsetzungsprodukt von

2

c1) 99 bis 55 Gew.%, vorzugsweise 97 bis 75 Gew.%, bezogen auf die Summe der Komponenten (c1) und (c2), eines mit Isocyanat härtbaren und vernetzbaren Celluloseethers und

c2) 1 bis 45 Gew.%, vorzugsweise 3 bis 25 Gew.%, bezogen auf die Summe der Komponenten (c1) und (c2), eines Polyisocyanats.

Unter Prozeßlösungsmitteln sollen dabei im Rahmen dieser Erfindung diejenigen Lösungsmittel verstanden werden, die bei der Herstellung, Verarbeitung oder Anwendung der Mehrschichten-Elemente — im unbelichteten als auch im belichteten Zustand — zum Einsatz gelangen. Hierzu gehören insbesondere die Lösungsmittel oder Lösungsmittelgemische, die bei der Herstellung der photosensitiven Schicht, dem Auswaschen und Entwickeln der belichteten Mehrschichten-Elemente sowie als Druckfarbenlösungsmittel beim Drucken mit aus den erfindungsgemäßen Mehrschichten-Elementen hergestellten Reliefdruckformen verwendet werden. Bei diesen Prozeßlösungsmitteln handelt es sich in aller Regel um organische Lösungsmittel, und zwar insbesondere um aromatische und halogenierte aliphatische Kohlenwasserstoff-Lösungsmittel als Verarbeitungs- und Entwickler-Lösungsmittel sowie um Alkohole, Ester und Ketone als Druckfarbenlösungsmittel.

Die hervorragenden Verbundeigenschaften, die die erfindungsgemäßen Mehrschichten-Elemente aufweisen, sind umso überraschender, als eine Verträglichkeit zwischen den in der Haftschicht (c) zum Einsatz gelangenden Celluloseethern und den in der photosensitiven Schicht (a) enthaltenen Materialien nicht zu erwarten war. Nachdem ein Klebstoff aus z. B. einem Copolyester und einem Isocyanat, wie er u. a. gemäß der DE-OS 22 15 090 oder CH-PS 421 708 als Haftschicht bei der Herstellung von Mehrschichten-Elementen mit einer photopolymerisierbaren elastomeren Schicht und einer Polyesterfolie als Trägerschicht eingesetzt werden soll, nur zu einem unbefriedigenden Ergebnis führt, stand es nicht zu erwarten, daß die erfindungsgemäßen Mehrschichten-Elemente nicht nur vor sondern auch nach der Belichtung und Entwicklung der photosensitiven Schicht eine gute Haft- und Verbundfestigkeit aufweisen, obwohl die Behandlung der Schichten mit dem Entwickler-Lösungsmittel und den Druckfarben-Lösungsmitteln und das dadurch mögliche Anquellen der Schichtbestandteile bekanntlich eine Verminderung der Verbundfestigkeit bewirken können und besondere Probleme bei der Herstellung haftfester schichtförmiger Verbundelemente darstellen. Insbesondere war es auch keineswegs vorherzusehen, daß erfindungsgemäß eine gute Haft- und Verbundfestigkeit mit zufriedenstellender Beständigkeit gegenüber so unterschiedlichen Lösungsmitteln wie aromatischen Kohlenwasserstoffen einerseits sowie Alkoholen und Estern andererseits erzielt werden konnte.

Als photoempfindliche Schicht (a) einer in aromatischen oder halogenierten aliphatischen Kohlenwasserstoff-Lösungsmitteln löslichen und/oder dispergierbaren Mischung von

a1) mindestens einem elastomeren Polymeren als Bindemittel,

a2) mindestens einem damit verträglichen photopolymerisierbaren ethylenisch ungesättigten Monomeren,

a3) mindestens einem Photopolymerisationsinitiator und ggf.

a4) die Handhabbarkeit und/oder Verarbeitbarkeit verbessernden Zusatzstoffen

kommen beispielsweise Mischungen in Frage, wie sie in den eingangs zitierten Druckschriften, insbesondere den DE-OSen 21 38 582, 22 15 090, 24 56 439 und 29 42 183, beschrieben sind. Elastomere Polymere, die in aromatischen oder halogenierten aliphatischen Kohlenwasserstoff-Lösungsmitteln löslich und/oder quellbar sind und somit als Bindemittel (a1) in Betracht kommen, sind insbesondere die entsprechenden Polymeren von konjugierten aliphatischen Dienen mit 4 bis 5 Kohlenstoffatomen. Als Beispiele hierfür seien genannt : Naturkautschuk, die Homopolymerisate von Butadien und Isopren, Copolymerisate von Butadien und Isopren untereinander sowie die Copolymerisate von Butadien und/oder Isopren mit anderen copolymerisierbaren Monomeren, wie insbesondere Styrol, Acrylnitril, (Meth)-acrylsäurealkylestern mit 1 bis 8 Kohlenstoffatomen in der Alkylgruppe und anderen. Beispiele für solche Copolymerisate sind die Nitrilkautschuke (z. B. Butadien-Acrylnitril-Copolymerisate mit einem Acrylnitril-Gehalt von 20 bis 35 Gew.%) ; Copolymerisate aus Styrol und Butadien und/oder Isopren mit statistischer Verteilung der Monomeren und einem Gehalt an einpolymerisiertem Styrol von vorzugsweise 10 bis 50 Gew.% ; Blockcopolymerisate aus Styrolmonomeren und Butadien und/oder Isopren. Besonders günstig als Bindemittel (a1) sind Zweiblockcopolymerisate des Typs A-B und Dreiblockcopolymerisate des Typs A-B-A mit einem bzw. zwei thermoplastischen Styrolpolymerisat-Blöcken A und einem elastomeren Butadien- und/oder Isopren-Polymerisatblock B und einem Anteil an einpolymerisiertem Styrol im allgemeinen im Bereich von 10 bis 50 Gew.% sowie elastomere Dreiblockcopolymerisate des Typs A-B-C mit einem thermoplastischen, nicht-elastomeren Styrolpolymerisat-Block A, einem elastomeren Butadien- und/oder Isopren-Polymerisat-Block B und einem von B verschiedenen elastomeren Polymerblock C aus Butadien und/oder Isopren sowie ggf. Styrol, wie sie beispielsweise gemäß der DE-OS 29 42 183 als Bindemittel zum Einsatz gelangen sollen.

Bei den mit dem elastomeren Bindemittel (a1) verträglichen, photopolymerisierbaren, ethylenisch ungesättigten Monomeren (a2) sind die Ester der Acrylsäure und/oder Methacrylsäure mit ein- oder mehrwertigen Alkoholen von besonderer Bedeutung. Hierzu gehören unter anderem Butylacrylat, Butylmethacrylat, 2-Ethylhexylacrylat, Lauryl-(meth)-acrylat, Ethylenglykoldimethacrylat, Butandiol-1,4-diacrylat, Butandiol-1,4-dimethacrylat, Neopentylglykoldimethacrylat, 3-Methylpentandioldiacrylat, 2-Hydroxypropylacrylat, 2-Hydroxyethyl-(meth)-acrylat, Hexandiol-1,6-di-acrylat, Hexandiol-1,6-dimethacrylat, 1,1,1-Trimethylolpropantri-(meth)-acrylat, Di-, Tri- und Tetra-ethylenglykoldiacrylat, Tripropylenglykoldiacrylat, Pentaerythrittetraacrylat. Geeignet sind auch Vinylester aliphatischer Monocarbonsäuren, wie Vinyloleat, und Vinylether von Alkoholen, wie Octadecylvinylether oder Butandiol-1,4-divinylether.

Das Verhältnis von elastomerem Bindemittel (a1) zu den photopolymerisierbaren, ethylenisch ungesättigten Monomeren (a2) in der photosensitiven Schicht (a) liegt im allgemeinen im Bereich von 60 bis 95 Gew.% an elastomerem Bindemittel (a1) zu 5 bis 40 Gew % an photopolymerisierbaren, ethylenisch ungesättigten Monomeren (a2).

Die photosensitive Schicht (a) enthält darüberhinaus eine wirksame Menge. im allgemeinen 0,01 bis 10 Gew.% und insbesondere 0,05 bis 5 Gew.%, bezogen auf die Komponenten der photosensitiven Schicht (a), mindestens eines Photopolymerisationsinitiators, wie z. B. Benzoin oder Benzoinderivate, wie dessen Methyl-, Isopropyl-, n-Butyl- oder Isobutylether ; symmetrisch oder unsymmetrisch substituierte Benzilketale, wie Benzildimethylketal, Benzilmethylethylketal ; oder Acylphosphinoxide des Typs, wie sie z. B. in der DE-OS 29 09 992 beschrieben sind. Die photosensitive Schicht (a) kann ferner noch weitere Zusatzstoffe enthalten, wie sie zur Verbesserung der Handhabbarkeit und Verarbeitbarkeit von Mehrschichten-Elementen der in Rede stehenden Art üblich und bekannt sind. Hierzu gehören insbesondere thermische Polymerisationsinhibitoren, wie beispielsweise p-Methoxyphenol, Hydrochinon oder Salze des N-Nitrosocyclohexylhydroxylamins ; Farbstoffe, photochrome Substanzen, Antioxidantien und/oder Weichmacher. Die Zusatzstoffe sind in der photosensitiven Schicht (a) in den für diese Substanzen üblichen und bekannten Mengen enthalten, wobei der Gesamtanteil der Zusatzstoffe an der photosensitiven Schicht (a) im allgemeinen 30 Gew.% nicht übersteigen soll und insbesondere im Bereich von 5 bis 20 Gew.%, jeweils bezogen auf die Summe der Komponente der photosensitiven Schicht (a), liegt.

Als dimensionsstabiler Träger (b) für die photosensitive Schicht (a) dient bei den erfindungsgemäßen Mehrschichten-Elementen ein Polyesterformkörper, insbesondere eine Polyester-Folie, z. B. aus Polyethylenterephthalat oder Polybutylenterephthalat. Die als dimensionsstabiler Träger (b) eingesetzte Polyesterfolie hat — je nach Aufbau des Mehrschichten-Elementes — im allgemeinen eine Schichtdicke im Bereich von 50 bis 300 µm. Die Oberfläche der Polyesterfolie kann dabei zur Erzielung einer besseren Haftfestigkeit ggf. mechanisch, chemisch oder beispielsweise durch Substrieren mit einer dünnen Schicht, vorzugsweise in einer Stärke von 2 bis 25 µm, eines üblichen Ein- oder Mehrkomponenten-Klebers, beispielsweise auf Polyurethan- oder Polychloropren-Basis, vorbehandelt sein.

Erfindungsgemäß besitzen die Mehrschichten-Elemente zwischen der photosensitiven Schicht (a) und der dimensionsstabilen Trägerschicht (b) zur festen Verankerung dieser beiden Schichten eine dünne Haftschicht (c), die im wesentlichen gebildet wird aus einem in den bei der Herstellung, Verarbeitung oder Anwendung der erfindungsgemäßen Mehrschichten-Elemente zum Einsatz gelangenden Prozeßlösungsmitteln unlöslichen Reaktionsprodukt, erhalten durch Umsetzung von

c1) 99 bis 55 Gew.%, insbesondere 97 bis 75 Gew.%, bezogen auf die Summe der Komponenten (c1) und (c2), eines mit Isocyanat härtbaren und vernetzbaren, freie OH-Gruppen enthaltenden Celluloseethers und

c2) 1 bis 45 Gew.%, insbesondere 3 bis 25 Gew.%, bezogen auf die Summe der Komponenten (c1) und (c2), eines Polyisocyanats.

Zur Herstellung dieser Haftschicht geht man dementsprechend vorteilhaft von einer innigen Mischung des freie OH-Gruppen enthaltenden Celluloseethers und einer Isocyanat-Komponente aus.

Als härtbare und vernetzbare Celluloseether mit freien OH-Gruppen (c1) für die Herstellung der Haftschicht (c) eignen sich insbesondere Ethylcellulosen und Hydroxypropylcellulosen mit mittleren Molekulargewichten im Bereich von 30 000 bis 500 000, vorzugsweise von 50 000 bis 300 000, wie sie als solche an sich bekannt und handelsüblich sind. Besonders günstig sind Ethylcellulosen mit einem Ethoxygehalt von 45 bis 49 %, insbesondere von 47,5 % bis 49 %, und Viskositäten (gemessen bei Raumtemperatur in 5 gew.%iger Lösung in einem Lösungsmittelgemisch aus 80 Gew.-Teilen Toluol und 20 Gew.-Teilen Ethanol) im Bereich von 5 bis 50 mPas, bevorzugt im Bereich von 12 bis 24 mPas. In gleicher Weise vorteilhaft sind auch Hydroxypropylcellulosen mit einem mittleren Molekulargewicht von 60 000 bis 100 000. Um die Haftschicht (c) der erfindungsgemäßen Mehrschichten-Elemente in einfacher und vorteilhafter Weise herstellen zu können, sollen die Celluloseether (c1) im allgemeinen gut löslich sein. Als Lösungsmittel für die Ethylcellulosen eignen sich insbesondere Toluol und Xylol ; für die Hydroxypropylcellulosen sind beispielsweise Tetrahydrofuran, Methylenchlorid, Chloroform und Gemische aus Toluol und Essigsäureethylester im Volumenverhältnis 1 : 1 besonders geeignet. Die Zahl der freien Hydroxylgruppen in den Celluloseethern (c1), die für die Härtung und Vernetzung mit dem Polyisocyanat von Bedeutung ist, ist von der Art des jeweiligen Celluloseethers abhängig und kann dementsprechend in einem breiten Bereich variieren. Sie soll jedoch mindestens so groß sein, daß nach der Umsetzung mit dem Polyisocyanat ein Produkt resultiert, welches in den Prozeßlösungsmitteln nicht mehr löslich ist. Zur Herstellung der erfindungsgemäßen Haftschichten (c) können die Celluloseether allein oder auch in verträglicher Mischung miteinander eingesetzt werden.

Als Isocyanat-Komponente, die zur Härtung und Vernetzung der oben beschriebenen härtbaren Celluloseether (c1) bei der Herstellung der Haftschicht (c) verwendet wird, kommen die aus der Polyurethanchemie bekannten und üblichen Polyisocyanate in Betracht, insbesondere Di-, Tri- und Tetraurethane und vorzugsweise solche mit zwei oder mehr aromatisch gebundenen Isocyanatgruppen.

Als Beispiele hierfür seien genannt : 1,6-Hexamethylendiisocyanat, Dicyclohexylmethan-4,4'-diisocyanat,

4

**0 059 385**

Isophorondiisocyanat, 2,4- und 2,6-Toluylendiisocyanat, m-Phenylendiisocyanat, Xylylendiisocyanat, Diphenylmethan-4,4'-diisocyanat, Naphthylen-1,5-diisocyanat, 3,3'-Dimethyldiphenyl-4,4'-diisocyanat, Triphenylmethan-4,4',4''-triisocyanat, 1,4-Cyclohexylendiisocyanat und Thionophosphorsäure-tris-[p-isocyanatophenyl]-ester. Die Isocyanate werden für die Härtung der hydroxylgruppenhaltigen Celluloseether innerhalb des oben angegebenen Bereiches im allgemeinen in solchen Mengen eingesetzt, daß das Verhältnis der Äquivalente der NCO-Gruppen zu den freien OH-Gruppen der härtbaren Celluloseether von 0,8 bis 1,6, insbesondere von 1,0 bis 1,2, beträgt.

Das Vermischen der härtbaren Celluloseether (c1) und der Polyisocyanate (c2) zur Herstellung der erfindungsgemäßen Haftschicht (c) erfolgt zweckmäßigerweise durch gemeinsames Lösen der Komponenten in einem geeigneten Lösungsmittel oder Lösungsmittelgemisch, beispielsweise Toluol oder Mischungen von Toluol mit anderen aromatischen Lösungsmitteln, wie z. B. Xylol, und/oder anderen an sich bekannten Lösungsmitteln allgemeiner Art. Im allgemeinen enthalten diese Lösungen soviel Lösungsmittel, daß ihre Auslaufzeiten im Ford-Becher (Düse 4) bei Raumtemperatur etwa 19 Sekunden betragen. Die Lösung der Komponenten für die Haftschicht (c) wird dann in an sich bekannter Weise, z. B. durch Streichen, Aufwalzen, Spritzen oder Gießen, auf die als Träger (b) dienende Polyester-Folie aufgebracht. Nach Ablüften des Lösungsmittels wird die Schicht (c) bei höheren Temperaturen ggf. unter verringertem Druck getrocknet und eingebrannt. Die Stärke der aufgetragenen Schicht wird dabei zweckmäßigerweise so gewählt, daß die gehärtete Haftschicht (c) nach dem Einbrennen eine Schichtdicke von 2 bis 25 μm, insbesondere von 3 bis 12 μm, aufweist. Das Trocknen und Einbrennen, bei dem die Haftschicht (c) gehärtet wird, erfolgt üblicherweise bei Temperaturen im Bereich von 80 bis 200 °C, insbesondere 90 bis 150 °C, im allgemeinen innerhalb eines Zeitraumes von 0,5 bis 20 Minuten, insbesondere innerhalb von 0,5 bis 5 Minuten. Die optimale Erhitzungsdauer und -temperatur für eine Haftschicht hängt dabei von den verwendeten Komponenten ab und ist auf diese abzustimmen. Die Härtung und Vernetzung der Haftschicht (c) soll vorzugsweise soweit durchgeführt werden, daß nach der Härtung und Vernetzung die Haftschicht (c) in den Prozeß-Lösungsmitteln, insbesondere in aromatischen und/oder halogenierten aliphatischen Kohlenwasserstoff-Lösungsmitteln sowie in Alkoholen, Estern und Ketonen, unlöslich, aber eventuell noch anquellbar ist. Die Komponenten der Haftschicht (c) werden vorteilhafterweise so gewählt, daß die Haftschicht (c) nicht nur nach dem Härten, d. h. dem Trocknen und Einbrennen der Schicht, transparent ist, sondern auch nach einer Behandlung mit Lösungsmitteln, beispielsweise dem Auswaschen der belichteten Mehrschichten-Elemente, transparent bleibt. Dies bringt Vorteile bei der Handhabung und Anwendung der Mehrschicht-Elemente.

Den Mischungen der Komponenten für die Haftschicht (c) können bei der Herstellung natürlich auch Pigmente, Pigmentierhilfsmittel und sonstige, die Verarbeitung günstig beeinflussenden Stoffe zugesetzt werden, wie z. B. übliche Katalysatoren für die Beschleunigung der Polyisocyanathärtung. Häufig ist es von Vorteil, wenn die Haftschicht (c) als Lichthofschutz photoaktive Verbindungen und/oder Farbstoffe enthält, die Licht im aktinischen Wellenlängenbereich absorbieren. Dies ist insbesondere dann günstig, wenn die photosensitive Schicht (a) der Mehrschicht-Elemente nur verhältnismäßig dünn ist.

Die Farbstoffe können dabei in solchen Mengen in der Schicht (c) enthalten sein, daß hierdurch bis zu 40 % des einfallenden Lichts absorbiert werden. Die in der Haftschicht (c) enthaltenen Farbstoffe sollen dabei nicht in die photosensitive Schicht (a) diffundieren können und sollen, beispielsweise durch Restlösungsmittel in der photosensitiven Schicht (a) oder durch die Druckfarbenlösungsmittel, nicht extrahierbar sein. Geeignete Farbstoffe sind beispielsweise solche mit reaktiven Gruppen, die bei der Isocyanat-Härtung der Haftschicht (c) in dieser Schicht fixiert werden, z. B. Michlers Keton-Derivate mit zwei oder mehr Hydroxyl-Gruppen. Weiterhin sind nicht wandernde Farbstoffe geeignet, wie z. B. Zapponechtschwarz (C.I. 12195, solvent black 34), Auramin FA (C.I. 41000, basic yellow 2) oder Cellitonrot GG (C.I. 11210).

Die Herstellung der erfindungsgemäßen Mehrschicht-Elemente mit einer auf einer Polyester-Folie als Träger (b) aufgebrachten photosensitiven Schicht (a), die über die spezielle Haftschicht (c) fest haftend miteinander verbunden sind, kann auf an und für sich übliche und bekannte Weise erfolgen. Üblicherweise wird zunächst die Haftschicht (c) auf die als Trägerschicht (b) dienende Polyesterfolie in der oben beschriebenen Art und Weise aufgetragen und auf diesen Verbund aus gehärteter Haftschicht (c) und Trägerschicht (b) wird dann die photosensitive Schicht (a) beispielsweise durch Gießen einer Lösung der Komponenten der Schicht (a) und Abdampfen des Lösungsmittels, aufgebracht. Gleichermaßen kann natürlich die photosensitive Schicht (a) auch zunächst separat, beispielsweise durch Gießen aus einer Lösung oder durch Extrudieren, hergestellt werden und diese so vorgefertigte Schicht (a) anschließend auf den Verbund aus gehärteter Haftschicht (c) und Trägerschicht (b) auflaminiert oder aufgepreßt werden. Bei der letztgenannten Methode kann es zweckmäßig und vorteilhaft sein, vor dem Auflaminieren der vorgefertigten photosensitiven Schicht (a) die gehärtete Haftschicht (c) zuvor mit einer dünnen, etwa 5 bis 50 μm starken Oberschicht zu versehen, die die gleiche oder eine ähnliche Zusammensetzung wie die photosensitive Schicht (a) besitzt. Diese dünne Oberschicht wird dabei am besten durch Gießen aus einer Lösung der Komponenten erzeugt.

Die erfindungsgemäßen Mehrschichten-Elemente eignen sich insbesondere zur Herstellung von Druck- und Reliefformen, was in an sich bekannter Weise durch bildmäßiges Belichten der photosensitiven Schicht (a) mittels aktinischem Licht, vorzugsweise einer Wellenlänge im Bereich von 230 bis 450 nm, insbesondere von 300 bis 420 nm, und anschließendes Auswaschen der unbelichteten Bereiche mit

5

0 059 385

einem geeigneten Entwickler-Lösungsmittel, wie beispielsweise aromatischen Kohlenwasserstoffen oder halogenierten aliphatischen Kohlenwasserstoff-Lösungsmitteln erfolgen kann. Die photosensitive Schicht (a) hat im allgemeinen eine Schichtstärke im Bereich von 200 bis 7 000 μm. Da sich die erfindungsgemäßen Mehrschichten-Elemente insbesondere zur Herstellung von weichelastischen Druckplatten eignen, wie sie z. B. beim Flexodruck zur Anwendung kommen, hat die Reliefschicht (a) nach der Belichtung und Photovernetzung insbesondere eine Shore A-Härte (DIN 53 505) von 15 bis 70. Die erfindungsgemäßen Mehrschichten-Elemente eignen sich auch zur Herstellung von Reliefdruckplatten, wie sie z. B. in der DE-OS 24 44 118 beschrieben sind, bei denen die Trägerschicht (b) für die reliefbildende, photosensitive Schicht (a) ihrerseits nochmals mit einer elastomeren Unterschicht verbunden ist und somit gleichzeitig als Stabilisierungsschicht für den Verbund dient. Es werden Druck- und Reliefformen erhalten, deren Reliefs auch bei wiederholter und längerer Behandlung mit den Prozeß-Lösungsmitteln eine ausgezeichnete Haftung auf dem Polyester-Träger zeigen.

Die Erfindung wird durch die nachfolgenden Beispiele weiter erläutert. Die in den Beispielen genannten Teile und Prozente beziehen sich, soweit nicht anders angegeben, auf das Gewicht. Teile verhalten sich zu Volumenteilen wie kg zu Liter.

### Beispiel 1

Es wird eine Haftlacklösung aus 5 Teilen einer Ethylcellulose (Ethoxygehalt von 45,5 bis 46,8 %, Viskosität bei 25 °C von 12 bis 16 mPas, gemessen in 5 %iger Lösung eines Gemisches aus 80 Teilen Toluol und 20 Teilen Ethanol), 4,3 Teilen einer 67 %igen Lösung des Umsetzungsproduktes aus 3 Molen Toluylendiisocyanat mit 1 Mol Trimethylolpropan, 30 Teilen Methylenchlorid, 40 Teilen Toluol, 25 Teilen Butylacetat und 0,001 Teil Dibutylzinndilaurat hergestellt. Die Lösung ist klar, sofern die Ethylcellulose im Methylenchlorid vorgelöst wird.

Diese Lösung wird in einer solchen gleichmäßigen Dicke auf eine Polyesterfolie von 75 μm Dicke aufgebracht, daß nach dem Ablüften der Lösungsmittel und dem Einbrennen der Haftlackschicht für 5 Minuten bei 130 °C in einem Trockenschrank eine Trockenschichtdicke der Haftlackschicht von etwa 5 bis 5,5 μm resultiert. Proben dieser mit der Haftlackschicht versehenen Polyesterfolie werden für jeweils 24 Stunden bei Raumtemperatur in Ethanol, Essigsäureethylester, Toluol, Tetrachlorethylen bzw. einem Gemisch aus 7 Teilen Ethanol und 3 Teilen Essigsäureethylester gelagert. In allen Fällen ist die Haftlackschicht unlöslich und nach der Lösungsmittellagerung nicht von der Polyesterfolie abziehbar. Der Haftlack ist vor und nach der Lösungsmittellagerung klebfrei, klar und völlig transparent.

### Beispiel 2

Analog Beispiel 1 wird eine Haftlacklösung zubereitet aus 5 Teilen einer Ethylcellulose (Ethoxygehalt von 47,5 bis 49 % ; Viskosität bei 25 °C von 18 bis 24 mPas, gemessen in 5 %iger Lösung in einem Gemisch aus 80 Teilen Toluol und 20 Teilen Ethanol), 4,3 Teilen des Polyisocyanats von Beispiel 1, 75 Teilen Toluol, 10 Teilen Xylol, 15 Teilen Butylacetat und 0,001 Teil Dibutylzinndilaurat. Diese Haftlacklösung wird wie in Beispiel 1 auf eine Polyesterfolie aufgetragen, abgelüftet und eingebrannt. Die resultierende 5 μm starke, gehärtete Haftlackschicht zeigt eine gleich gute Lösungsmittelresistenz und Haftfestigkeit wie die Proben von Beispiel 1.

### Beispiel 3

Es wird wie in Beispiel 2 verfahren, nur werden diesmal als Polyisocyanat für die Herstellung des Haftlacks 3 g des Umsetzungsproduktes aus 3 Molen 1,6-Hexamethylendiisocyanat und 1 Mol Wasser als 75 %ige Lösung in Ethylglykolacetat/Xylol (1 : 1) eingesetzt. Die Verbunde aus gehärteter Haftlackschicht und Polyesterfolie werden wie in Beispiel 1 beschrieben geprüft und weisen die gleich guten Eigenschaften wie die Verbunde der Beispiele 1 und 2 auf. Insbesondere ist die gute Lösungsmittelresistenz zu erwähnen.

### Beispiel 4

Es wird wie im Beispiel 2 verfahren, nur wird das dort eingesetzte Polyisocyanat durch 8,2 g einer 20 %igen Lösung von Thionophosphorsäure-tris-[p-isocyanatophenyl]-ester in Methylenchlorid ersetzt. Die gemäß Beispiel 1 hergestellten Verbunde aus gehärteter Haftschicht und Polyesterfolie weisen gleich gute Eigenschaften auf wie die Proben der Beispiele 1 bis 3.

### Beispiel 5

Es wird wie in Beispiel 4 verfahren, nur wird für die Herstellung der Haftlackschicht kein Dibutylzinndilaurat mitverwendet. Die Ergebnisse unterscheiden sich von denen des Beispiels 4 nicht.

# 0 059 385

## Beispiel 6

Es wird wie in Beispiel 4 verfahren ; allerdings wird der Haftlack nach der Ablüftung der Lösungsmittel nur für 2 Minuten bei 115 °C eingebrannt. Der so erhaltene Haftlack ist gegen Ethanol und Tetrachlorethylen ähnlich resistent wie die in den Beispielen 1 bis 5 beschriebenen ; in Essigsäureethylester und Toluol zeigen sich nach 24 Stunden Lagerung geringfügige Anquellungen, was einen leichten Tack verursacht.

## Beispiel 7

Für eine Mehrschichtendruckplatte wird eine lichtempfindliche Schicht von 0,7 mm Dicke, hergestellt nach Beispiel 5 der DE-OS 29 42 183, auf eine weichelastische Unterschicht, hergestellt nach Beispiel 3 der DE-OS 29 42 183, aufgebracht, wobei zuvor die inmitten des Mehrschichten-Elements liegende Polyesterfolie von 75 μm Dicke der weichelastischen Unterschicht mit einem Haftlack nach dem Beispiel 4 in einer Dicke von 5 μm beschichtet wurde. Die Härtung der Haftlackschicht erfolgte bei 120 °C 10 min. Der Haftlack enthält als Lichthofschutz ein Gemisch aus 4,4'-Bis-(N-β-hydroxiethyl-N-. methyl-amino)-benzophenon und Auramin FA (BASF, Basic Yellow 2) im Verhältnis 4 : 1 ; die Extinktion der Haftlackschicht von 5 μm Dicke bei 360 nm wird auf 0,30 eingestellt.

Bei einer Belichtungstestreihe zeigte die Platte einen großen Belichtungsspielraum, d. h. freistehende Reliefelemente sehr geringen Durchmessers, wie Linien von 150 μm Dicke, sind breit versockelt auf der Polyesterfolie und haftfest mit ihr verbunden. Gleichzeitig zeigen die Näpfchen von Rasterfeldern noch sehr hohe Tiefenwerte, so daß randscharfe, saubere Druckergebnisse erhalten werden.

Wird auf eine derartige Platte eine Negativvorlage mit Gitterlinien, Linien, feinen Strichzeichnungen aufbelichtet (Belichtungszeit 12 min) und wird anschließend in einem handelsüblichen Sprühwascher mit einem Lösungsmittelgemisch von 8 : 2 Vol.-Teilen Tetrachlorethylen/n-Butanol 1 min länger als die erforderliche Auswaschzeit von 4 min entwickelt, so zeigen sich an den aufbelichteten Reliefteilen keinerlei Ablöseerscheinungen in der Form, daß sich Linien vom Haftgrund ablösen oder sich verziehen. Die Bildwiedergabe bleibt vorlagengetreu erhalten.

## Vergleichsbeispiel

Eine Mehrschichtenplatte wird wie in Beispiel 7 beschrieben gefertigt mit dem Unterschied, daß die Haftlackschicht aus 100 Teilen eines handelsüblichen Phenoxiharzes 114,6 Teilen Thionophosphorsäure-tris-[p-isocyanatophenyl]-ester sowie des gleichen Gemisches aus 4,4'-Bis-(N-β-hydroxiethyl-N-methyl-amino)-benzophenon und Auramin FA als Lichthofschutz mit gleicher Lichtabsorption von E = 0,3 bei 360 nm bei 5 μm Dicke besteht.

Die Haftlackschicht wird aus einer Lösung in Tetrahydrofuran aufgetragen, daß eine Schichtdicke von ca. 5 bis 7 μm resultiert, und bei 120 °C 10 min getrocknet. Die lichtempfindliche Schicht wird in gleicher Weise wie in Beispiel 7 mit einem feine Linien, Gitter und Strichzeichnungen enthaltenden Negativ 12 min belichtet und anschließend 5 min im gleichen Lösungsmittel wie in Beispiel 7 entwickelt. Die Linien und Gitter zeigen insbesondere an den auslaufenden Enden deutliche Ablöseerscheinungen, die auf mangelnde Haftung zurückzuführen sind.

## Beispiel 8

Eine Mehrschichtenplatte gemäß DE-OS 29 42 183 wurde hergestellt aus

a) einer lichtempfindlichen Reliefschicht bestehend aus 85 Teilen eines ABC-Blockcopolymeren (Block A: Polystyrol, Block B: Polyisopren, Block C: Styrol/Butadien-Copolymer ; Verhältnis A : B : C = 1 : 7,6 : 1,4), 5 Teilen Hexandiol-1,6-diacrylat, 5 Teilen Butandiol-1,4-dimethacrylat, 2 Teilen Trimethylolpropantriacrylat, 1,0 Teilen Benzildimethylketal, 0,5 Teilen 2,6-Di-tert.-butyl-p-kresol, 0,006 Teilen eines schwarzen Farbstoffs (C.I. 26150, Solvent Black 3) und 5 Teilen eines Paraffinöls (mediz. Weißöl) ;

b) einer Unterschicht aus 60 Teilen des gleichen Blockcopolymeren, 30 Teilen Paraffinöl, 10 Teilen Hexandiol-1,6-dimethacrylat, 0,6 Teilen Benzildimethylketal.

Eine 75 μm dicke Polyesterfolie wird beidseitig mit einer Haftlackschicht nach Beispiel 2 in 6 μm Dicke beschichtet. Die Haftlackschicht zur Reliefschicht ist zusätzlich mit einem nicht extrahierbaren Farbstoff (Cellitonrot GG, C.I. 11210) und 4,4'-Bis-(N-β-hydroxiethyl-N-methylamino)-benzophenon als Lichthofschutz eingefärbt. Bevor die Reliefschicht aufkaschiert wird, wird auf die gehärtete Haftlackschicht eine weitere Schicht in 20 μm Dicke aus 90 Teilen des ABC-Blockcopolymeren der Reliefschicht, 10 Teilen Hexandiol-1,6-dimethacrylat, 1,5 Teilen Benzildimethylketal aufgetragen und 130 sec mit einem Flachbelichter vorbelichtet. Anschließend wird auf die klebrige Oberfläche die bereits vorbereitete Reliefschicht aufgewalzt. Die Haftwerte der unbelichteten Schicht liegen bereits so hoch, daß sie ohne Zerreißen nicht abziehbar ist. Nach vollflächiger Belichtung (20 min), Auswaschen (4 min) und Trocknen (80 °C, 1 Stunde) liegen die Haftwerte > 3 kp/2 cm, der Haftlack ist nicht von der Polyesterfolie ablösbar.

7

Nach 6-stündigem Tauchen in einem Gemisch aus 7 Teilen Ethanol und 3 Teilen Essigester ist die Haftung nur unwesentlich abgesunken. Ablöseerscheinungen treten nicht auf.

Beispiel 9

Es wurde ein Haftlack zubereitet aus 5 Teilen einer Hydroxypropylcellulose (mittleres Molekulargewicht 60 000, Substitutionsgrad von 3), 34,8 Teilen einer 20 %igen Lösung von Thionophosphorsäure-tris-[p-isocyanatophenyl]-ester, 250 Teilen wasserfreiem Tetrahydrofuran und solchen Mengen an 4,4'-Bis-[N-β-hydroxyethyl-N-methylamino]-benzophenon und Cellitonrot GG im Verhältnis 3 : 1, daß nach der Einbrennung des Haftlackes auf einer Polyesterfolie (5 min bei 130 °C) die 5 μm dicke Haftschicht eine Gesamtextinktion bei 360 nm von 0,30 hatte. Auf die eingebrannte, gehärtete Haftschicht wurde ein Oberlack entsprechend Beispiel 8 in einer Dicke von 20 μm aufgebracht, der nach Ablüften der inkorporierten Lösungsmittel für 5 Minuten bei 100 °C getrocknet wurde. Danach wurde der Mehrschichten-Verbund vollflächig 2 Minuten in einem Flachbelichter belichtet. Dann wurde darüber eine photosensitive reliefbildende Schicht gemäß Beispiel 8 auflaminiert unter Benutzung von Toluol als Kaschierhilfsmittel. Diese Mehrschichtenplatte wurde dann volltonmäßig belichtet und in 2 cm breite Streifen geschnitten. An diesen Streifen wurde vor und nach der Lagerung für 24 Stunden in Ethanol, Essigsäureethylester, 1,1,1-Trichlorethan, Toluol bzw. einem 4 : 1 Tetrachlorethan/n-Butanol-Gemisch die Haftkraft ermittelt. Sie war jeweils höher als die Kohäsion der belichteten Reliefschicht, so daß keine Haftwerte bestimmt werden konnten.

Beispiel 10

Auf eine Haftschicht nach Beispiel 5 wird eine Oberlackschicht von 25 μm Dicke aus 90 Teilen eines ABC-Blockcopolymeren gemäß Beispiel 8, 10 Teilen Trimethylolpropantriacrylat und 2 Teilen Benzoinmethylether aufgetragen und belichtet. Darauf wird eine photoempfindliche Reliefdruckschicht aus 90 Teilen eines Acrylnitril-Butadien-Kautschuks mit 28 % Acrylnitrilgehalt und einer Mooney Viskosität von 40,4 Teilen Hexandiol-1,6-diacrylat, 4 Teilen Hexandiol-1,6-dimethacrylat, 3 Teilen Trimethylolpropantriacrylat, 1,3 Teilen Benzildimethylketal, 0,005 Teilen Sudantiefschwarz (Solvent Black 3, C.l. 26150) aufgebracht. Nach 30-minütigem Belichten der 1,7 mm dicken Reliefschicht, 5-minütigem Auswaschen in 1,1,1-Trichlorethan werden Haftkraftwerte von 2,8 kp/2 cm gemessen. Nach Lagerung der belichteten Platte in Essigsäureethylester für 24 Stunden werden Haftkraftwerte > 1 kp/2 cm ermittelt.

**Ansprüche**

1. Zur Herstellung von Druck- und Reliefformen geeignete Mehrschichten-Elemente mit
a) einer photosensitiven Schicht einer in aromatischen oder halogenierten aliphatischen Kohlenwasserstoff-Lösungsmitteln löslichen und/oder dispergierbaren Mischung, bestehend im wesentlichen aus
a1) mindestens einem elastomeren Polymeren als Bindemittel,
a2) mindestens einem damit verträglichen photopolymerisierbaren, ethylenisch ungesättigten Monomeren,
a3) einem durch aktinisches Licht aktivierbaren Photopolymerisationsinitiator sowie ggf.
a4) üblichen Zusatzstoffen,
b) einem Polyesterformkörper als dimensionsstabilem Träger für die photosensitive Schicht (a) und
c) einer dünnen Haftschicht zwischen der photosensitiven Schicht (a) und dem dimensionsstabilen Träger (b) in einer Schichtdicke von 2 bis 25 μm,
dadurch gekennzeichnet, daß die Haftschicht (c) im wesentlichen gebildet wird aus einem in den bei der Herstellung, Verarbeitung oder Anwendung der Mehrschichten-Elemente zum Einsatz gelangenden Prozeß-Lösungsmitteln nicht löslichen Umsetzungsprodukt von
c1) 99 bis 55 Gew.%, bezogen auf die Summe der Komponenten (c1) und (c2), eines mit Isocyanat härtbaren und vernetzbaren Celluloseethers und
c2) 1 bis 45 Gew.%, bezogen auf die Summe der Komponenten (c1) und (c2), eines Polyisocyanats.

2. Mehrschichten-Elemente gemäß Anspruch 1, dadurch gekennzeichnet, daß die Haftschicht (c) zusätzlich photoaktive Komponenten und/oder Farbstoffe enthält.

3. Mehrschichten-Elemente gemäß Ansprüchen 1 oder 2, dadurch gekennzeichnet, daß sie als Träger (b) eine gegebenenfalls mechanisch, chemisch und/oder durch Versehen mit einer Haftgrundierung vorbehandelte Polyesterfolie enthalten.

4. Mehrschichten-Elemente gemäß Ansprüchen 1 bis 3, dadurch gekennzeichnet, daß sie zwischen der Haftschicht (c) und der photosensitiven Schicht (a) eine weitere, in den aromatischen oder halogenierten aliphatischen Kohlenwasserstoff-Lösungsmitteln nicht lösliche, aber quellbare haftvermittelnde Schicht mit einer Schichtdicke von 5 bis 50 μm, vorzugsweise 12 bis 32 μm, enthalten.

5. Mehrschichten-Element nach Ansprüchen 1 bis 4, dadurch gekennzeichnet, daß die härtbaren Celluloseether (c1) ein mittleres Molekulargewicht von 30 000 bis 500 000 haben.

6. Mehrschichten-Element nach Anspruch 5, dadurch gekennzeichnet, daß die härtbaren Celluloseether (c1) einen mittleren Veretherungsgrad von 2,15 bis 2,6 aufweisen.

7. Mehrschichten-Element nach Anspruch 5, dadurch gekennzeichnet, daß der härtbare Celluloseether (c1) eine Ethylcellulose mit einem Ethoxigehalt von 45 bis 49 % ist.

8. Mehrschichten-Element nach Anspruch 5, dadurch gekennzeichnet, daß der härtbare Celluloseether (c1) eine Hydroxypropylcellulose mit einem mittleren Molekulargewicht von 50 000 bis 300 000 und einem Gehalt von 2,5 bis 3 freier OH-Gruppen pro polymerer Einheit ist.

9. Mehrschichten-Element nach Ansprüchen 1 bis 8, dadurch gekennzeichnet, daß das Polyisocyanat (c2) das Umsetzungsprodukt aus 1 Mol 1,1,1-Trimethylolpropan und 1 Mol Toluylendiisocyanat, das Umsetzungsprodukt aus 3 Molen 1,6-Hexamethylendiisocyanat und 1 Mol Wasser oder Thionophosphorsäure-tris-[p-isocyanatophenyl]-ester ist.

10. Verfahren zur Herstellung von Mehrschichten-Elementen gemäß Ansprüchen 1 bis 9, gekennzeichnet durch

(1) schichtförmiges Auftragen eines Haftlackes, enthaltend — jeweils bezogen auf die umzusetzenden Produkte — 99 bis 55 Gew.% eines härtbaren Celluloseethers und 1 bis 45 Gew.% eines Polyisocyanats, auf einen Polyesterformkörper als dimensionsstabilen Träger (b) und Einbrennen des Haftlacks unter Bildung einer 2 bis 25 µm dicken, in den Prozeß-Lösungsmitteln unlöslichen Haftschicht (c),

(2) gegebenenfalls Aufbringen einer weiteren Haftschicht mit verbesserter Haftung zur photosensitiven Schicht (a), sowie

(3) Aufbringen der photosensitiven Schicht (a) auf die oberste Haftschicht.

11. Verwendung der Mehrschichten-Elemente gemäß Ansprüchen 1 bis 9 zur Herstellung von Reliefdruckformen für den Flexodruck, insbesondere für den Druck mit alkohol-, keton- oder esterhaltigen Druckfarben.

### Claims

1. A multi-layer element suitable for the production of printing plates and relief plates, and comprising

a) a photosensitive layer of a mixture which is soluble and/or dispersible in aromatic hydrocarbon solvents or aliphatic halohydrocarbon solvents and consists essentially of

a1) at least one elastomeric polymer as the binder,

a2) at least one photopolymerizable, ethylenically unsaturated monomer compatible with the binder, and

a3) at least one photopolymerization initiator activatable by actinic light, with or without

a4) conventional additives

b) a polyester shaped article as a dimensionally stable base for the photosensitive layer (a) and

c) a 2-25 µm thick adhesive layer between the photosensitive layer (a) and the dimensionally stable base (b), wherein the adhesive layer (c) consists essentially of a reaction product, which is insoluble in the process solvents used during the production, processing or use of the multi-layer element, of

c1) from 99 to 55 % by weight, based on the sum of the components (c1) and (c2), of a cellulose ether which is crosslinkable and hardenable with an isocyanate, and

c2) from 1 to 45 % by weight, based on the sum of the components (c1) and (c2), of a polyisocyanate.

2. A multi-layer element as claimed in claim 1, wherein the adhesive layer (c) addiitionally contains photoactive components and/or dyes.

3. A multi-layer element as claimed in claim 1 or 2, containing, as the base (b), a polyester film which may have been pre-treated mechanically, chemically and/or by providing it with an adhesive coating.

4. A multi-layer element as claimed in claims 1 to 3, containing, between the adhesive layer (c) and the photosensitive layer (a), an adhesion-promoting layer which is from 5 to 50 µm, preferably from 12 to 32 µm, thick and is insoluble, but can be swollen, in the aromatic hydrocarbon solvents or aliphatic halohydrocarbon solvents.

5. A multi-layer element as claimed in claims 1 to 4, wherein the hardenable cellulose ether (c1) has a mean molecular weight of from 30,000 to 500,000.

6. A multi-layer element as claimed in claim 5, wherein the hardenable cellulose ether (c1) has a mean degree of etherification of from 2.15 to 2.6.

7. A multi-layer element as claimed in claim 5, wherein the hardenable cellulose ether (c1) is an ethylcellulose having an ethoxy content of from 45 to 49 %.

8. A multi-layer element as claimed in claim 5, wherein the hardenable cellulose ether (c1) is a hydroxypropylcellulose having a mean molecular weight of from 50,000 to 300,000 and containing from 2.5 to 3 free OH groups per polymer unit.

9. A multi-layer element as claimed in claims 1 to 8, wherein the polyisocyanate (c2) is the reaction product of 1 mole of 1,1,1-trimethylolpropane and 1 mole of toluylene diisocyanate, the reaction product of 3 moles of hexamethylene 1,6-diisocyanate and 1 mole of water, or tris-(p-isocyanatophenyl) thionophosphate.

10. A process for the production of a multi-layer element as claimed in claims 1 to 9, comprising

(1) applying a layer of an adhesive, consisting of from 99 to 55 % by weight of a hardenable cellulose ether and from 1 to 45 % by weight of a polyisocyanate, based on the reactants in each case, to a polyester shaped article as the dimensionally stable base (b), and baking the applied layer of adhesive to form a 2-25 μm thick adhesive layer (c) which is insoluble in the process solvents,

(2) optionally applying an adhesion-promoting layer to the photosensitive layer (a), and

(3) applying the photosensitive layer (a) to the adhesive layer.

11. The use of a multi-layer element as claimed in claims 1 to 9 for the production of relief plates for flexographic printing, especially for printing with alcohol-, ketone- or ester-containing printing inks.

## Revendications

1. Eléments multi-couches convenant pour la préparation de formes d'impression et en relief, comprenant :

a) une couche photosensible formée d'un mélange soluble et(ou) dispersable dans des solvants hydrocarbonés aromatiques et aliphatiques halogénés, constitué essentiellement de :

a1) au moins un polymère élastomère servant de liant,

a2) au moins un monomère à insaturation éthylénique compatible avec a1) et photopolymérisable,

a3) un initiateur de la photopolymérisation activable par la lumière actinique et éventuellement

a4) des additifs usuels ;

b) un élément façonné en polyester comme support dimensionnellement stable pour la couche photosensible (a) et

c) une mince couche d'adhérence entre la couche photosensible (a) et le support dimensionnellement stable (b), d'une épaisseur comprise entre 2 et 25 μm, caractérisés en ce que la couche d'adhérence (c) est essentiellement formée d'un produit de la réaction de

c1) 99 à 55 % en poids, par rapport à la somme des composants (c1) et (c2), d'un éther cellulosique réticulable et durcissable par un isocyanate avec

c2) 1 à 45 % en poids, par rapport à la somme des composants (c1) et (c2), d'un polyisocyanate, qui n'est pas soluble dans les solvants opératoires, mis en œuvre lors de la préparation, la transformation et(ou) l'utilisation des éléments multi-couches.

2. Eléments multi-couches suivant la revendication 1, caractérisés en ce que la couche d'adhérence (c) contient en outre des composants photo-actifs et(ou) des colorants.

3. Eléments multi-couches suivant la revendication 1 ou la revendication 2, caractérisés en ce qu'ils comprennent comme support (b) une feuille en polyester, éventuellement pré-traitée par voie mécanique ou chimique et(ou) munie d'une couche d'adhérence de base.

4. Eléments multi-couches suivant les revendications 1 à 3, caractérisés en ce qu'ils comprennent, entre la couche d'adhérence (c) et la couche photosensible (a), une couche d'adhérence supplémentaire insoluble, mais gonflable, dans les solvants hydrocarbonés aromatiques et aliphatiques halogénés, d'une épaisseur de 5 à 50 μm et de préférence de 2 à 32 μm.

5. Elément multi-couches suivant les revendications 1 à 4, caractérisé en ce que l'éther cellulosique durcissable (c1) est choisi parmi les éthers cellulosiques avec un poids moléculaire moyen de 30 000 à 500 000.

6. Elément multi-couches suivant la revendication 5, caractérisé en ce que l'éther cellulosique durcissable (c1) possède un degré moyen d'éthérification entre 2,15 et 2,6.

7. Elément multi-couche suivant la revendication 5, caractérisé en ce que l'éther cellulosique durcissable (c1) est une éthyl-cellulose avec une teneur en groupes éthoxy entre 45 et 49 %.

8. Elément multi-couche suivant la revendication 5, caractérisé en ce que l'éther cellulosique durcissable (c1) est une hydroxypropyl-cellulose avec un poids moléculaire moyen de 50 000 à 300 000 et une proportion de 2,5 à 3 groupes OH libres par unité polymère.

9. Elément multi-couche suivant les revendications 1 à 8, caractérisé en ce que le polyisocyanate (c2) est le produit de la réaction de 1 mole de triméthylol-1,1,1 propane et de 1 mole de diisocyanate de toluylène ou le produit de la réaction de 3 moles de diisocyanate-1,6 d'hexaméthylène et de 1 mole d'eau ou l'ester de tris-(p-isocyanato-phényle) de l'acide thiono-phosphorique.

10. Procédé de préparation d'éléments multi-couches suivant les revendications 1 à 9, caractérisé en ce que :

(1) on applique sur un élément façonné en polyester, servant de support dimensionnellement stable (b), une couche d'un vernis d'adhérence, composé de 99 à 55 % de son poids d'un éther cellulosique durcissable et de 1 à 45 % de son poids d'un polyisocyanate, que l'on transforme par cuisson en une couche d'adhérence (c) d'une épaisseur de 2 à 25 μm, insoluble dans les solvants opératoires ;

(2) on applique éventuellement une couche d'adhérence supplémentaire pour améliorer l'adhérence de la couche photosensible (a) et, sur la couche d'adhérence supérieure,

(3) on applique une couche photosensible (a).

11. Utilisation d'éléments multi-couches suivant les revendications 1 à 9 pour la préparation de formes d'impression en relief pour l'impression flexographique, en particulier pour l'impression avec des encres contenant un alcool, une cétone ou un ester.